# EUROPEAN PATENT SPECIFICATION

(11) **EP 0 383 034 B1**
(45) Date of publication and mention of the grant of the patent: **25.09.1996**
(21) Application number: 90100912.6
(22) Date of filing: 17.01.1990
(51) Int. Cl.: H01L 27/06

(54) **Integrated circuit and method**
Integrierte Schaltung und Herstellungsverfahren
Circuit intégré et son procédé de fabrication

(30) Priority: 16.02.1989 US 312100
(43) Date of publication of application: 22.08.1990
(73) Proprietor: TEXAS INSTRUMENTS INCORPORATED, Dallas Texas 75265 (US)
(72) Inventor: Bayraktaroglu, Burhan, Plano, Texas 75075 (US)
(74) Representative: Leiser, Gottfried, Dipl.-Ing.

(56) References cited:
- EP-A- 0 276 981
- GB-A- 2 162 370
- US-A- 4 611 388
- NEW ELECTRONICS, vol. 18, no. 13, June 1985, pages 27-29,31,33,34,37, London, GB; E. WATSON: "Gallium arsenide ICS come out of the research shadows"
- IEEE: GaAs IC SYMPOSIUM - TECHNICAL DIGEST, Portland, Oregon, 13th-16th October 1987, pages 137-140, IEEE; A.K. OKI et al.: "High performance GaAs/AlGaAs heterojunction bipolar transistor 4-bit and 2-bit A/D converters and 8-bit D/A converter"

## Description

### BACKGROUND OF THE INVENTION

### 1. Field of the Invention.

The present invention relates to semiconductor electronic integrated circuits, and, more particularly, to an integrated circuit including both bipolar transistors and MESFET devices based on II-IV or III-V alloy semiconductor materials.

### 2. Description of the Related Art.

Microwave components and subsystems may be generally divided into two classes: (1) hybrid and (2) monolithic integrated circuit (MMIC). Hybrid technology permits combinations of varying device types, circuits on varying substrate types, and passive components that are not entirely compatible with the MMIC technology. The best use of hybrid technology arises when high performance is required from a given circuit. In this case discrete devices (of possibly various types) are chosen and screened to insure maximum performance, passive circuits are produced on low loss substrates, and after devices are connected to the circuits some tuning is applied to obtain the maximum performnace for the resulting hybrid arrangement.

Conversely, MMIC technology is based on the use of only one type of device performing all of the circuits functions. The commonly used device type is the Schottky barrier gate GaAs field effect transistor (MESFET). The MESFET is flexible enough to be used in low noise amplifier, power amplifier, switch, mixer, doubler, and many other circuits. It performs most of these functions satisfactorily but none of them optimally. Other types of devices such as (high electron mobility transistors (HEMTs), heterojunction bipolar transistors (HBTs), and mixer diodes that can perform low noise, high power, or mixer functions better individually than MESFETs; but using one of these devices as only device type in MMIC circuits improves one function while degrading others. The performance degradation resulting from the nonoptimal use of active devices is partly offset by the monolithic integration of passive circuits and active devices. In addition, batch processing offered by MMIC technology improves circuit complexity and lowers fabrication cost.

Silicon digital circuits make use of vertical *npn* switching transistors as well as lateral *pnp* transistors for input logic, current sources and level shifting. The addition of junction field effect transistors (JFETs) with silicon bipolar transistors result in analog circuits which operate at high speeds while offering very high input impedences. The versatility of combining bipolar circuits and JFETs in a silicon integrated circuit is well known.

Historically GaAs/AlGaAs heterojunction bipolar transistors (HBT) have been fabricated using mesa technology in which the collector, base and emitter epi layers are sequentially grown during a single epitaxial deposition run. The emitter and base epi layer are selectively removed using two etch steps for making contact to the base and collector areas, respectively. These etches result in steps in the GaAs ranging in height between 0.4 and 1.0 micron for a typical mesa HBTs. See for example, K.Nagata et al, Self-Aligned AlGaAs/GaAs HBT with Low Emitter Resistance Utilizing InGaAs Cap Layer, 35 IEEE Tr.Elec.Dev. 2 (1988). Although high quality HBTs can be fabricated in this manner, the resulting mesa structure results in very severe topography making it difficult to incorporate a multilevel metal system as required for high levels of integration.

Planar heterojunction bipolar transistors have been fabricated as elements of integrated circuits in the emitter down configuration; see for example, L.Tran et al, GaAs/AlGaAs Heterojunction Emitter-Down Bipolar Transistors Fabricated on GaAs-on-Si Substrate, 8 IEEE Elec.Dev.Lett. 50 (1987). This avoids the mesa topography but has the drawbacks of limited *npn* base doping and limited multiple device integration possibilities. The deep base implant through the collector limits the base doping resulting in a high base sheet resistance and a "flat" doping profile. The integration possibilities have been explored in copending application serial no. 063,554, filed June 18, 1987 (L.Tran) not published prior to the present application where an *n*-channel JFET was proposed with the *npn.* To integrate any more devices would require major changes in the epi and many additional processing steps. In addition, this technology requires all of the *npn* transistors to be connected in the common emitter configuration which severely limits its applications.

Although a single epitaxial deposition run as used in the mesa HBTs and emitter-down HBTs does simplify the fabrication process, it limits the types of structures which can be integrated together on a single chip.

U.S. Patent No. 4,529,996 discloses an InP-BP heterojunction bipolar transistor in which a boron phosphide emitter is grown through an opening in a silicon dioxide mask on a indium phosphide substrate containing base and collector regions.

US 4,611,388 discloses a heterojunction bipolar transistor with active regions formed in epitaxially grown area. The article "Gallium Arsenide ICs come out of the Research Shadows" (New Electronics, Vol. 18, No. 13, June 1985, at page 37) describes an alternative HBT structure, and also describes conventional MESFET arrangements at pages 33 and 34. Use of HBTs integrated together with diodes and resistors in an integrated circuit is described in IEEE: GaAsIC Symposium - Technical Digest, Portland 13-16th October 1987, at pages 137 to 140.

However, overgrowth methods have the drawbacks of not integrating multiple devices into the process and requiring spatially selective deposition of epitaxial layers. In the case of selective epi deposition, the epi material that falls on the silicon dioxide mask is wasted, and the selective epi process can lead to severe interface problems at the edges of openings in the silicon dioxide mask, resulting in regions of high stress and defect levels. The work of J.W. Tully, 7 IEEE Elec.Dev.Lett. 203 (1986) in emitter overgrowth onto an implanted base used Zn as a dopant because of the high mass and low implant range, however Zn diffuses rapidly in an uncontrolled manner at the temperatures needed for the second epi growth. Additionally, Tully integrates only a single type of device, the *npn* HBT.

Thus the known MMIC methods have a problem of integrating GaAs MESFETs with HBTs.

### SUMMARY OF THE INVENTION

The above described problems are solved by the integrated circuit having the features of claim 1.

The present invention provides monolithically integrated MESFETs and HBTs and a fabrication method including selective implantations followed by epitaxial growth of base and emitter layers for the HBT. This process allows integration in semi-insulating GaAs which provides isolation of devices without trenches or lattice damage implants.

In preferred embodiments, first HBT collector and MESFET channel and contact regions are implanted into a semi-insulating GaAs wafer and then epitaxial *in situ* doped base and emitter layers are grown over the entire wafer. The emitter and base layers are patterned and etched in a self-aligned process followed by the MESFET recessed gate process. This provides a simple process yielding a quasi-planar vertical HBTs together with MESFETs.

This solves the problems of the known methods of integrating different devices by providing a simple process with quasi-planar vertical devices.

### BRIEF DESCRIPTION OF THE DRAWINGS

The drawings are schematic and the vertical scale has been exaggerated for clarity.
Figures 1-10 are cross sectional elevation views of a first preferred embodiment and the steps of a first preferred embodiment fabrication method;
Figure 11 illustrates schematically an integrated circuit using both low noise amplifier devices and power amplifier devices; and
Figure 12 is a plan view of a first preferred embodiment HBT.

### DESCRIPTION OF THE PREFERRED EMBODIMENTS

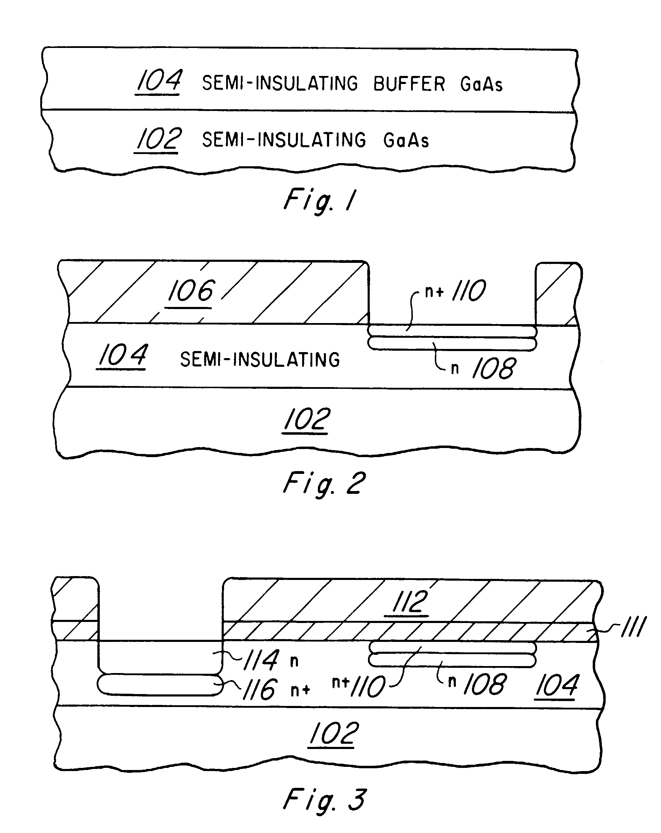

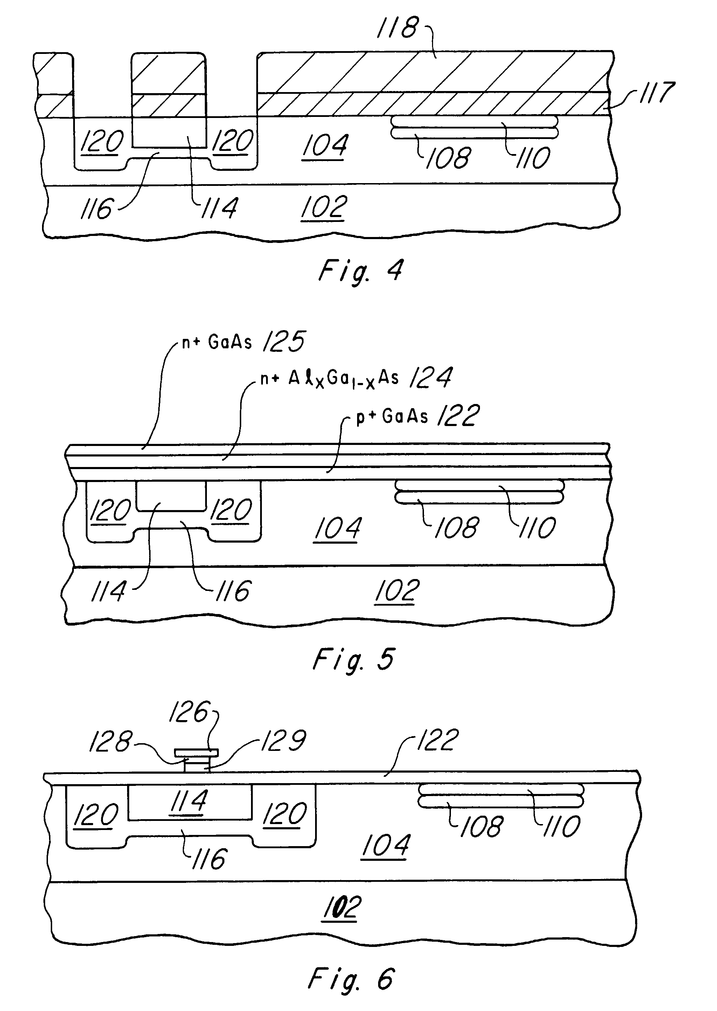

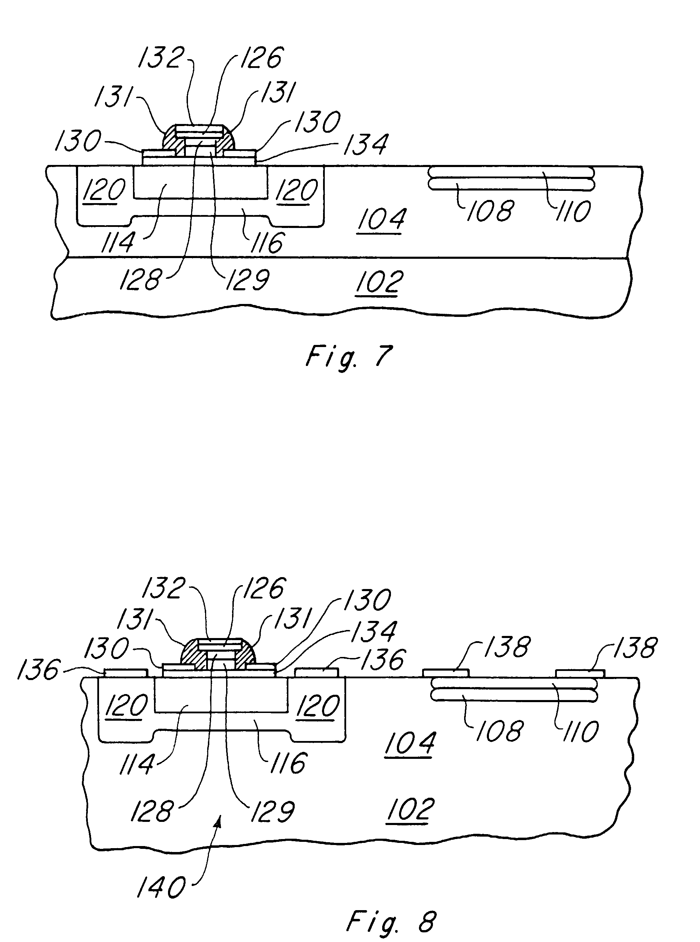

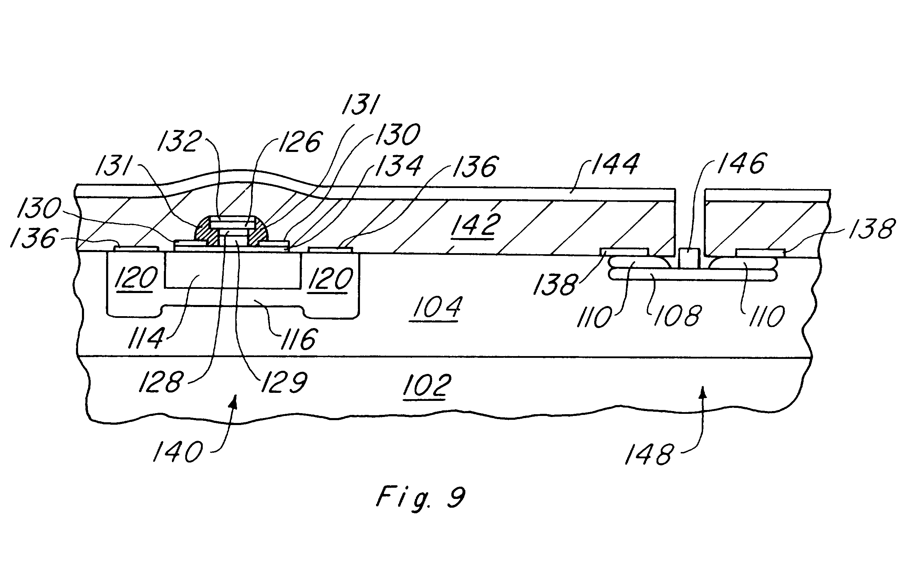

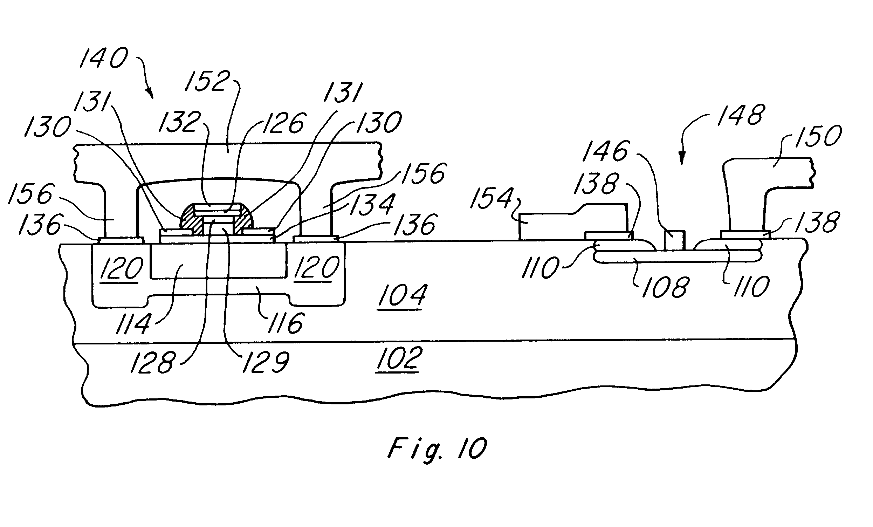

First preferred embodiment method for simultaneously fabricating high power *npn* heterojunction bipolar transistors (HBTs) and low noise *n*-channel MESFETs includes the following steps as illustrated in cross sectional elevation views in Figures 1-10:
(a) A starting material for this process in shown in Figure 1; note that the vertical is exaggerated in the drawings for clarity. It is composed of a semi-insulating GaAs substrate 102 oriented in the (100) direction on which 1 micron thick epitaxial layer 104 of semi-insulating GaAs has been grown. The epitaxial layer 104 is optional and could be omitted.
(b) Photoresist 106 is spun on the starting material and patterned to define the location of the *n*-channel MESFET. Using photoresist 106 as an implant mask, silicon is implanted into epilayer 104 at an energy of 200 keV and dose of 5 × 10¹²/cm² to form channel region 108 doped about 2 × 10¹⁷/cm³ and situated from about 0.1 µm to 0.3 µm beneath the surface. Next, silicon is again implanted but at an energy of 60 keV and dose of 3 × 10¹³/cm² to form contact layer 110 doped about 2 × 10¹⁸/cm³ and extending from about the surface to channel region 108. See Figure 2; these implants will be activated in step (e).
(c) Photoresist 106 is stripped and a 1 µm thick layer of silicon nitride (Si₃N₄) 111 is deposited on the surface. A thick (2-3 µm) layer of photoresist 112 is then spun on and patterned to define the location of the *npn* HBT. The photoresist 112 pattern is transferred to nitride 111 by reactive ion etching (RIE) in 92% CF₄/8% O₂. Using photoresist 112 plus nitride 111 as an implant mask, silicon is implanted into epilayer 104 at energies of 150, 300, and 600 keV with doses of 5 × 10¹¹/cm², 8 × 10¹¹/cm², and 1.2 × 10¹²/cm², respectively, to form *n* collector region 114 doped about 3 × 10¹⁶/cm³ and extending from the surface to about 0.6 µm beneath the surface. Next, silicon is again implanted but at an energy of 900-1200 keV and dose of 8 × 10¹³/cm² to form *n*+ layer 116 dopped about 2 × 10¹⁸/cm³ and extending from about the collector region 114 to about 0.5 µm beneath the surface. See Figure 3; these implants will also be activated in step (e).
(d) Photoresist 112 is stripped and nitride 111 is removed. A 1 µm thick layer 117 of nitride is deposited on the surface and photoresist 118 is spun on and patterned to define the location of the collector contacts in the *npn* HBT. The pattern is transferred to nitride 117 by RIE as in step (c). Using photoresist 118 and nitride 117 as an implant mask, silicon is implanted into epilayer 104 at energies of 200, 500, and 900 keV with doses of 5 × 10¹³/cm², 6 × 10¹³/cm², and 8 × 10¹³/cm², respectively, to form *n*+ collector contacts 120 doped about 2 × 10¹⁸/cm³ and extending from the surface to subcollector 116. See Figure 4; these implants will also be activated in step (e).
(e) Photoresist 118 is stripped, nitride 117 is removed, and the surface is cleaned. Then an epitaxial metalorganic chemical vapor deposition (MOCVD) is performed at temperatures of about 800 C in an overpressure of arsenic to grow further layers on layer 104; this anneals the previously described implants of silicon resulting in good electrical activation. As an alternative, the substrate can be annealed in a conventional furnace or rapid thermal annealer prior to the epi growth. The epi growth first forms epilayer 122 of *p*⁺ GaAs of thickness 0.05-0.1 µm and *in situ* doped with zinc (or with beryllium if layer 122 is grown by molecular beam epitaxy (MBE)) to about 1 × 10¹⁹/cm³. Then epilayer 124 of *n*⁺ Al_{*x*}Ga₁₋_{*x*}As (*x* = 0.25) of thickness 0.1 µm and *in situ* doped with silicon to about 2 × 10¹⁷/cm³ and epilayer 125 of *n*⁺ GaAs of thickness 0.1 µm and *in situ* doped with silicon to about 3 × 10¹⁸/cm³ are grown. See Figure 5. Alternatively, the growth may be immediately preceded by a 900 C anneal for fifteen minutes in the MOCVD reactor, or the growth may be by MBE rather than MOCVD.
   The specific layer composition deposited during the epi growth depends upon optimization of the HBT because none of the deposited layers will be used in the MESFET; indeed, the MESFET regions could be masked off during the deposition, but this is superfluous in that the formation of the emitter and base of the HBT will necessarily require removal of portions of the deposited layers.
(f) After the epi growth, photoresist is spun on and patterned to define the location of the emitter of the HBT. Metal (50 nm (500Å) Au:Ge/14 nm (140 Å)Ni/200 nm (2,000 Å) Au) is evaporated onto the photoresist and the exposed portion of epilayer 125, and the photoresist is removed which lifts off the metal except the portion 126 which is on GaAs epilayer 125. Metal 126 is then used as an etch mask for RIE etching GaAs epilayer 125 and Al_{*x*}Ga₁₋_{*x*}As epilayer 124 with BCl₃. This etch is anisotropic but slightly etches the GaAs and Al_{*x*}Ga₁₋_{*x*}As under metal 126 to leave an overhang of about 0.05 µm of metal on the remaining portions 128 of GaAs layer 125 and 129 of Al_{*x*}Ga₁₋_{*x*}As layer 124; see Figure 6. GaAs 128 will form the emitter contact layer and Al_{*x*}Ga₁₋_{*x*}As 129 will form the emitter for the HBT. Emitter 129 may be about 2 µm by 10 µm with the 2 µm width shown in the cross sectional view in Figure 6.
(g) Photoresist is again spun on and patterned to define the location of the base of the HBT; this exposes metal 126 in addition to a portion of *p*⁺ GaAs 122. Metal (also Au:Ge/Ni/Au) is evaporated onto the photoresist and metal 126 plus the exposed portion of epilayer 122. The overhanging metal 126 shadows the part of epilayer 122 adjacent emitter 129, so the evaporated metal does not contact emitter 129. The photoresist is removed which lifts off the metal except the portion 130 which is on GaAs epilayer 122 and the portion 132 which is on metal 126. A 0.5 µm thick layer of nitride is conformally deposited and anisotropically etched by RIE to remove all of the nitride except the portion 131 on the sidewalls of the emitter 129 and emitter contact 128. Nitride 131 fills the gap between emitter 129 and metal 130 which will form the base contact. Metal 130 and 132 plus nitride 131 are then used as an etch mask for anisotropically etching *p*⁺ GaAs epilayer 122 by RIE with BCl₃ to form base 134. The etch is timed to stop once the *p*⁺ GaAs layer 122 outside of base 134 is removed; a slight overetch into the *n* and semi-insulating GaAs does not disrupt the HBT and MESFET being fabricated. See Figure 7; base 134 may be about 4 µm by 10 µm.
(h) Photoresist is spun on and patterned to define ohmic contacts for both the HBT collector contacts 120 and source/drain of the MESFET. Gold/germanium/nickel is evaporated on and lifted off by removing the photoresist; this forms collector ohmic contacts 136 and source/drain ohmic contacts 138 and completes the HBT, generally denoted by reference numeral 140. The ohmic contacts are alloyed at 435 C for two minutes. See Figure 8.
(i) Photoresist 142 is spun on and patterned to define the recessed gate for the MESFET. An isotropic etch of water, hydrogen perioxide, and sulfuric acid (H₂O:H₂O₂:H₂SO₄) is used to etch *n*⁺ GaAs region 110 and stop on *n*⁻ GaAs channel region 108; this etch undercuts the photoresist 142. Titanium/platinum/gold 144 is deposited by evaporation to form gate 146; see Figure 9 which shows that gate 146 is spaced away from *n*⁺ GaAs contact regions 110 by the undercut during the etch. Photoresist 142 is removed and this completes the MESFET, generally denoted by reference numeral 148.
(j) Other items such as impedance matching, air bridges 150 and 152 with supports 156, metal interconnections 154, and vias to backside ground are formed by conventional technologies. See Figure 10. These other items may couple HBT 140 with MESFET 148 and other HBTs and MESFETs all integrated on the semi-insulating substrate 102-104. Substrate 102 may have a backside metal ground plane with vias from the ground plane to interconnections or other items on the surface with HBT 140 and MESFET 148.

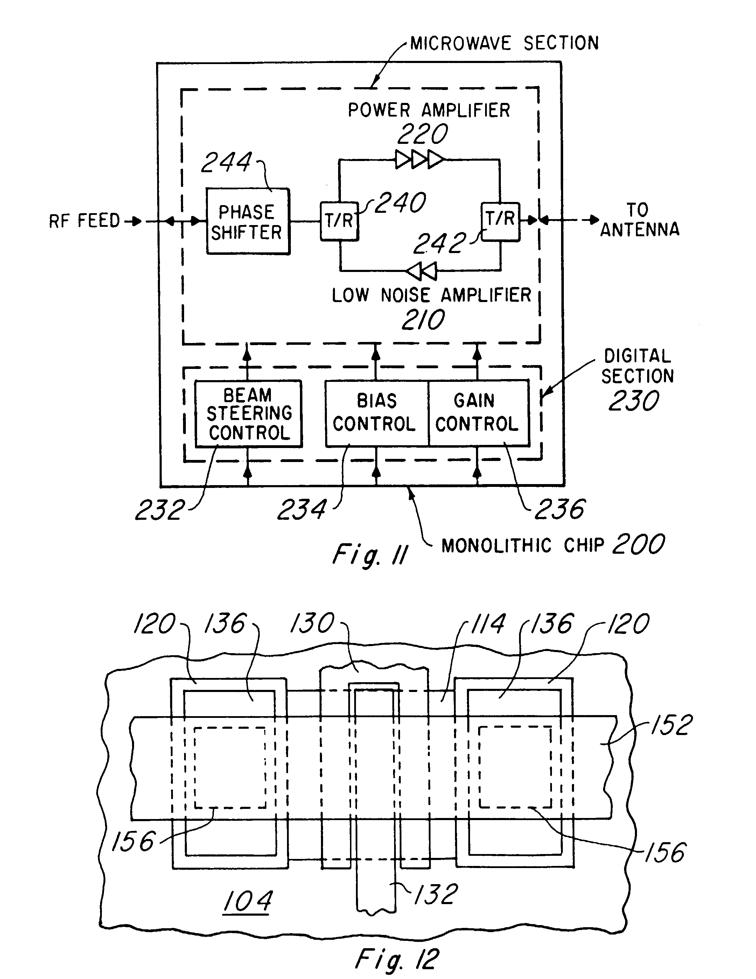

Figure 11 schematically illustrates an application of the first preferred embodiment: an integrated circuit (monolithic chip 200) that contains both low noise MESFETs in low noise amplifier 210 and HBTs in power amplifier 220. Monolithic chip 200 provides a module that could be used in a phased array radar system. The digital control portion 230 of chip 200 (beam steering control section 232, bias control section 234, and gain control section 236) may be made of HBTs, transmit/receive switches 240 and 242 may be made of MESFETs, and phase shifter 244 may be made of MESFETs. The performance limiting portions of chip 200 are low noise amplfier 210 and power amplifier 220; so by integrating MESFETs with HBTs, the overall performance is optimized.

### MODIFICATIONS AND ADVANTAGES

Various modifications of the preferred embodiment devices and methods may be made while retaining the features of quasiplanar and electrically isolated transistors.

For example, for high power HBT structures the implantation of the collector may use high energies that will require an implant mask other than the photoresist plus nitride used in the preferred embodiments; the MESFET gate can be fabricated by optolithography (for ≥ 1µm gate length) or electron beam lithography (for ≤ 1µm gate length); the HBT implantations may be performed prior to the MESFET implantations or even in interleaved order and *p-n-p* HBTs and *p* channel MESFETs may be included by varying the implantation or *in situ* dopants or growing undoped epilayers and selectively doping them by diffusion or implantation; other semiconductor materials such as other III-V alloys or II-VI alloys may be used and the semi-insulating substrate may be GaAs-on-silicon or other compound structures; the bandgap of the base material may be graded to provide built-in acceleration of the minority carriers to the collector such as making the base of Al_{*x*}Ga₁₋_{*x*}As with *x* varying from 0.05 at the emitter to 0.0 at the collector; a wide-gate-recess etch for the MESFET may be used in which the *n*⁺ layer (plus a portion of the *n* layer) is etched away with a first phtotresist mask and then the gate applied with a second photoresist mask; the MESFET may be fabricated without the heavily doped contact layer and without gate recess; and the element shapes, dimensions, topologies, and topographies may be varied. Indeed, with an elongated emitter and base (see plan view in Figure 12), the evaporation of metal 130 may be angled using the emitter structure 129, 128, 126 as part of the mask to offset metal 130 from the emitter structure; the evaporation would require two evaporations steps: one for each side of the emitter structure. This extra offsetting of metal 130 from the emitter structure lessens the leakage and shorts from emitter to base as the thicknesses of emitter 129 and emitter contact 128 are decreased. Figure 12 has the same reference numerals as Figure 10 for the corresponding elements of HBT 140.

Advantages of the first preferred embodiment method include its simplicity and quasi-planar surface (the base 134 is only 0.05 µm thick and emitter contact 128 plus emitter 129 are only 0.2 µm thick and metal 126 and 132 are 0.2 µm thick, so the total height of the HBT structure above the (collector) surface is only 0.45 µm. Also, the transistors are implanted directly into the semi-insulating substrate and are isolated so no lattice damage or trench isolation is required, and the HBTs and MESFETs are separately implanted, so they may be individually optimized.

## Claims

1. An integrated circuit including both bipolar transistors (140) and MESFET devices (148) based on II-VI or III-V alloy semiconductor materials comprising:
(a) a first layer (104) of semi-insulating semiconductor material;
(b) a doped channel region (108) in said first layer (104) extending to and along a first principal surface of said first layer (104);
(c) a doped collector region (114) in said first layer (104) extending to and along said surface, said doped collector region (114) being laterally spaced from said doped channel region (108);
(d) a doped semiconductor base layer (134) located on top of said first layer (104) on said collector region (114) and forming an interface with said doped collector region (114) at said surface, said base layer (134) being of a conductivity type opposite that of said collector region (114);
(e) a doped semiconductor emitter layer (129) located on top of said base layer (134), said emitter layer (129) being of the same conductivity type as said collector region (114);
(f) source and drain contacts (138) on said channel region (108);
(g) a metal gate (146) on said channel region (108) between said source and drain contacts (138); and
(h) electrical coupling between a bipolar transistor (140) including said emitter layer, base layer, and collector region and a MESFET (148) including said metal gate (146) and said channel region (108).

2. The integrated circuit of claim 1, wherein:
said emitter layer (129) is made of semiconductor material with a wider bandgap than said base layer semiconductor material.

3. The integrated circuit of claim 1 or 2, wherein:
said emitter layer (129) plus said base layer (134) have a total thickness of less than 0.5µm.

4. The integrated circuit of claim 1, 2 or 3, wherein:
(a) said first layer (104) is GaAs;
(b) said base layer (134) is GaAs; and
(c) said emitter layer (129) is AlₓGa₁₋ₓAs.

5. The integrated circuit of claim 4, wherein:
(a) said channel region (108) is *n* type;
(b) said collector region (114) is doped *n* type;
(c) said base layer (134) is *p* type; and
(d) said emitter layer (129) is *n* type.

6. The integrated circuit of any preceding claim, wherein:
(a) said source and drain contacts (138) include first doped contact regions (110) of said first layer (104) located between portions of said channel region (108) and said first surface, said first doped contact regions (110) of the same conductivity type as and more heavily doped than said channel regions (108); and
(b) said collector region (114) includes collector contact regions (120) which are more heavily doped than the portion of said collector region (114) abutting said base layer (134).

7. The integrated circuit of any preceding claim, wherein:
said first surface is nonplanar at said gate and said gate is recessed.

8. The integrated circuit of claim 1, wherein:
said emitter layer includes an emitter contact sublayer (128) and an emitter sublayer (129), said emitter sublayer (129) abuts said base layer (134) and said emitter contact sublayer (128) abuts said emitter sublayer (129), said emitter sublayer (129) made of semiconductor material with a wider bandgap than said base layer semiconductor material, and said emitter contact sublayer (128) made of semiconductor material with a narrower bandgap than said emitter sublayer semiconductor material.

## Patentansprüche

1. Integrierte Schaltung mit sowohl bipolaren Transistoren (140) als auch MESFET-Vorrichtungen (148) auf der Basis von II-VI oder III-V-Legierungshalbleitermaterialien, enthaltend:
(a) eine erste Schicht (104) aus halbisolierendem Halbleitermaterial;
(b) eine dotierte Kanalzone (108) in der ersten Schicht (104), die sich zu und längs einer ersten Hauptfläche der ersten Schicht (104) erstreckt;
(c) eine dotierte Kollektorzone (114) in der ersten Schicht (104), die sich zu und längs der Fläche erstreckt, wobei die dotierte Kollektorzone (114) seitlich im Abstand von der dotierten Kanalzone (108) liegt;
(d) eine dotierte Halbleiter-Basisschicht (134), die sich auf der ersten Schicht (104) auf der Kollektorzone (114) befindet und eine Grenzfläche mit der dotierten Kollektorzone (114) an der Fläche bildet, wobei die Basisschicht (134) einen Leitungstyp hat, der dem der Kollektorzone (114) entgegengesetzt ist;
(e) eine dotierte Halbleiter-Emitterschicht (129), die sich auf der Basisschicht (134) befindet, wobei die Emitterschicht (129) den gleichen Leitungstyp wie die Kollektorzone (114) hat;
(f) Source- und Drain-Kontakte (138) auf der Kanalzone (108);
(g) ein Metall-Gate (146) auf der Kanalzone (108) zwischen den Source- und Drain-Kontakten (138); und
(h) eine elektrische Kopplung zwischen einem bipolaren Transistor (140), der die Emitterschicht, die Basisschicht und die Kollektorzone enthält, sowie einem MESFET (148), der das Metall-Gate (146) und die Kanalzone (108) enthält.

2. Integrierte Schaltung nach Anspruch 1, bei welcher:
die Emitterschicht (129) aus Halbleitermaterial mit einem weiteren Bandabstand als das Halbleitermaterial der Basisschicht gebildet ist.

3. Integrierte Schaltung nach Anspruch 1 oder 2, bei welcher:
die Emitterschicht (129) und die Basisschicht (134) eine Gesamtdicke von weniger als 0,5 µm haben.

4. Integrierte Schaltung nach Anspruch 1, 2 oder 3, bei welcher:
(a) die erste Schicht (104) aus GaAs besteht;
(b) die Basisschicht (134) aus GaAs besteht; und
(c) die Emitterschicht (129) aus AlₓGa₁₋ₓAs besteht.

5. Integrierte Schaltung nach Anspruch 4, bei welcher:
(a) die Kanalzone (108) n-leitend ist;
(b) die Kollektorzone (114) n-leitend dotiert ist;
(c) die Basisschicht (134) p-leitend ist; und
(d) die Emitterschicht (129) n-leitend ist.

6. Integrierte Schaltung nach einem der vorhergehenden Ansprüche, bei welcher:
(a) die Source- und Drain-Kontakte (138) die erste dotierte Kontaktzonen (110) der ersten Schicht (104) zwischen Abschnitten der Kanalzone (108) und der ersten Fläche enthalten, wobei die ersten dotierten Kontaktzonen (110) den gleichen Leitungstyp bei stärkerer Dotierung wie die Kanalzonen (108) haben; und
(b) die Kollektorzone (114) Kollektorkontaktzonen (120) enthält, die stärker dotiert sind als der an die Basisschicht (134) angrenzende Abschnitt der Kollektorzone (114).

7. Integrierte Schaltung nach einem der vorhergehenden Ansprüche, bei welcher die erste Fläche bei dem Gate nicht eben ist und das Gate mit einer Ausnehmung versehen ist.

8. Integrierte Schaltung nach Anspruch 1, bei welcher:
die Emitterschicht eine Emitterkontakt-Teilschicht (128) und eine Emitter-Teilschicht (129) enthält, wobei die Emitter-Teilschicht (129) an die Basisschicht (134) angrenzt und die Emitterkontakt-Teilschicht (128) an die Emitter-Teilschicht (129) angrenzt, wobei die Emitter-Teilschicht (129) aus einem Halbleitermaterial mit einem breiteren Bandabstand als das Halbleitermaterial der Basisschicht gebildet ist und die Emitterkontakt-Teilschicht (128) aus einem Halbleitermaterial mit engerem Bandabstand als das Halbleitermaterial der Emitter-Teilschicht gebildet ist.

## Revendications

1. Circuit intégré comportant une paire de transistors bipolaires (140) et de dispositifs MESFET (148) basés sur des matériaux semiconducteur en alliage II-VI ou III-V comprenant :
(a) une première couche (104) d'un matériau semiconducteur semi-isolant ;
(b) une région de canal dopée (108) dans ladite première couche (104) s'étendant vers et le long d'une première surface principale de ladite première couche (104) ;
(c) une région de collecteur dopée (114) dans ladite première couche (104) s'étendant vers et le long de ladite surface, ladite région de collecteur dopée (114) étant latéralement espacée de ladite région de canal dopée (108) ;
(d) une couche de base semiconductrice dopée (134) située sur le dessus de ladite première couche (104) sur ladite région de collecteur (114) et formant une interface avec ladite région de collecteur dopée (114) sur ladite surface, ladite couche de base (114) étant d'un type de conductivité opposé à celui de ladite région de collecteur (114) ;
(e) une couche d'émetteur semiconductrice dopée (129) située sur le dessus de ladite couche de base (1 14), ladite couche d'émetteur (129) étant du même type de conductivité que la région de collecteur (114) ;
(f) des contacts de source et de drain (138) sur ladite région de canal (108) ;
(g) une grille métallique (146) sur ladite région de canal (108) entre lesdits contacts de source et de drain (138) ; et
(h) un couplage électrique entre un transistor bipolaire (140) comportant ladite couche d'émetteur, ladite couche de base et ladite région de collecteur, et un MESFET (148) comportant ladite grille métallique (146) et ladite région de canal (108).

2. Circuit intégré selon la revendication 1, dans lequel ladite couche d'émetteur (129) est réalisée en un matériau semiconducteur avec une bande interdite plus large que le matériau semiconducteur de la couche de base.

3. Circuit intégré selon l'une des revendications 1 ou 2, dans lequel :
ladite couche d'émetteur (129) plus ladite couche de base (134)) ont une épaisseur totale inférieure à 0,5 µm.

4. Circuit intégré selon l'une quelconque des revendications 1 à 3, dans lequel :
(a) ladite première couche (104) est en GaAs ;
(b) ladite couche de base (134) est en GaAS ; et
(c) ladite couche d'émetteur (129) est en AlₓGa₁₋ₓAs.

5. Circuit intégré selon la revendication 4, dans lequel:
(a) ladite région de canal (108) est de type n ;
(b) ladite région de collecteur (114) est dopée de type n;
(c) ladite couche de base (134) est de type p ; et
(d) ladite couche d'émetteur (129) est de type n.

6. Circuit intégré selon l'une quelconque des revendications précédentes, dans lequel :
(a) lesdits contacts de source et de drain (138) comportent des premières régions de contact dopées (110) de ladite première couche (104) situées entre des parties de ladite région de canal (108) et de ladite première surface, lesdites premières régions de contact dopées (110)) étant du même type de conductivité que les régions de canal (108) et dopées plus fortement que celles-ci ; et
(b) ladite région de collecteur (114) comporte des régions de contact de collecteur (120) qui sont plus fortement dopées que la partie de la région de collecteur (114) en appui sur ladite couche de base (134).

7. Circuit intégré selon l'une quelconque des revendications précédentes, dans lequel :
ladite première surface est non plane au niveau ladite grille et ladite grille comporte un évidement.

8. Circuit intégré selon la revendication 1, dans lequel :
ladite couche d'émetteur comporte une sous couche de contact d'émetteur (128) et une sous couche d'émetteur (129), ladit sous couche d'émetteur (129) s'appuyant sur ladite couche de base (134) et ladite sous couche de contact d'émetteur (128) s'appuyant sur ladite sous couche d'émetteur (129), ladite sous couche d'émetteur (129) étant réalisée en un matériau semiconducteur avec une bande interdite plus large que le matériau semiconducteur de la couche de base, et ladite sous couche de contact d'émetteur (128) étant réalisée en un matériau semiconducteur avec une bande interdite plus étroite que le matériau semiconducteur de la sous couche d'émetteur.
